# EUROPEAN PATENT APPLICATION

(11) **EP 4 124 189 A1**
(43) Date of publication of application: **25.01.2023**
(21) Application number: 21187056.3
(22) Date of filing: 21.07.2021
(51) Int. Cl.: H05K 7/20

(54) **CLOSED HOUSING FOR AN ELECTRONIC COMPONENT**

(71) Applicant: HENSOLDT Sensors GmbH, 82024 Taufkirchen (DE)
(72) Inventor: KONOPA, Christoph Sebastian, 89182 Bernstadt (DE); FÜLLER, Manuel, 89073 Ulm (DE); BARTH, Philipp Alexander, 88480 Achstetten (DE)
(74) Representative: LifeTech IP Spies & Behrndt Patentanwälte PartG mbB

(57) **Abstract**

A closed housing (100) for an electronic component (50) comprises a duct structure (110). The duct structure (110) passes through the housing (100), and has a surface (112) on an interior side of the housing (100) for attaching the electronic component (50). The duct structure (110) is configured to admit a circulation of air from an environment of the housing (100) through the duct structure (110). The air does not enter the housing (100). By the circulation of air, a cooling effect is provided for the electronic component (50).

## Description

The present invention relates to closed housing for an electronic component and to a method for providing a cooling effect for the electronic component in the closed housing, and in particular to an improvement of power dissipation of convection cooled housings by introduction of air ducts.

### BACKGROUND

Housings for electronic devices shield their content from environmental influences. This function needs to be balanced with the requirement to exchange matter and energy with the environment, and in particular with the need to dissipate heat produced in the housing during operation of electronic components. In situations where the housing must seal its content in a water- or even airtight manner there is no option for cooling by active ventilation. Common alternatives include e.g. thermoelectric or compression-based air conditioners. However, devices of that kind usually require a power source, which may not be available or unfeasible due to spatial restrictions, costs, or because of an associated additional production of heat.

For these reasons there exist several structural measures for providing a cooling effect to the content of a housing. Spatial extension permitting, heat pipes may be employed to transfer heat from a component to e.g. a wall of the housing. Another measure is to place components which generate particularly large amounts of heat, or particularly sensitive equipment, in immediate contact with outside walls of the housing, relying on convection for an improved dissipation of heat energy. A further measure is to increase an area of a surface of the housing by fins designed to provide a better heat dissipation.

However, there are cases where a large number of components must be stored in a housing of limited space, still requiring efficient dissipation of heat energy. Particular examples are active radar sensor devices, especially in the military sector, which must deliver high operational performance with as little energy output as possible, in a restricted room, and even in severe environmental conditions. Especially for these cases there is a demand for efficient measures to dissipate heat generated in electronic components out of the closed housing.

### SUMMARY OF THE INVENTION

At least some of the above-mentioned problems are solved by a closed housing for an electronic component according to claim 1, a radar apparatus according to claim 8, and by a method for providing a cooling effect for an electronic component in a closed housing according to claim 10. The dependent claims refer to further advantageous realizations for the subject matters of the independent claims.

The present invention relates to a closed housing for an electronic component, wherein the housing comprises a duct structure. The duct structure passes through the housing, and has a surface on an interior side of the housing for attaching the electronic component. The duct structure is configured to admit a circulation of air, or of another medium (like e.g. water) in the environment of the housing, through the duct structure. The air circulated through the duct structure does not enter the housing. By means of the circulation of air, the duct structure provides a cooling effect for the electronic component. Effectively the duct structure acts as a heat sink for heat produced in the housing during operation of the electronic component.

The material of the duct structure may be the same as that of the housing (e.g. a metal). However, the duct structure may also comprise materials which do not appear in the rest of the housing. The duct structure may comprise one or more distinct substructures, such as e.g. several canals. It may provide more than one surface directed towards the inside of the housing for attaching components. The duct structure, or a particular substructure of it, is not merely a groove or dent in a surface of the housing, but may e.g. pass through the housing to connect two opposite outer surfaces of the housing. If the housing is viewed effectively as a two-dimensional closed surface, the duct structure increases the genus of the housing by at least 1. For example, in a cross section perpendicular to the exemplary air circulation the duct structure may be a rectangular shape surrounded by the interior of the housing to allow a plane surface for mounting the electronic component.

The expression "for attaching the electronic component" should be understood broadly. Thus, the surface of the duct structure to which the electronic component can be attached may comprise particular elements for holding or fixing an electronic component, but it may also be smooth, with the electronic component to be placed in contact with it, or merely next to it.

The electronic component may be any part of an electronic device encased in the housing. In particular, it may be a graphics or other processing unit, or a printed circuit board. The surface may also serve as an end point of an internal heat pipe configured to carry heat from some source in the apparatus to the surface in order to cool a heat transfer fluid in the heat pipe, and thereby provide cooling to some electronic component located further away from the duct structure within the housing. Also, an internal ventilation device may be provided for revolving air inside the housing, and in particular for passing a stream of heated air along or towards the surface of the duct structure for cooling. It is understood that in embodiments, more than one electronic component may be attached to the surface of the duct structure.

Optionally the housing, including the duct structure, encloses the electronic component in a waterproof and/or airtight manner. Therefore, the housing may be suitable for outdoor applications and protects the interior from moisture, dust etc. The duct structure is particularly advantageous if no ventilation or other exchange of matter between the inside and the outside of the housing is provided.

Optionally the duct structure (or any individual substructure of it) comprises a plurality of channels configured to provide or improve a stack effect, or chimney effect, for cooling the electronic component. If a channel is sized appropriately (e.g. has a small diameter compared to a length of the channel), heat produced by the electronic component may lead to a buoyancy force on the air or other medium circulating through the channel. Channels may be configured to support this effect by further means, e.g. by a difference in local diameter or cross-section at the entrance and/or exit of the channel, or at or around the position where the electronic component is to be placed.

Optionally the plurality of channels is formed by fins comprised in the duct structure, or in a particular substructure of it. The fins may e.g. run along the duct structure, and divide the duct structure into the plurality of channels.

Optionally the duct structure comprises a heat pipe for cooling the electronic component. Advantageously the heat pipe comprises a heat transfer fluid which is adapted to absorb heat energy from the electronic component, and the heat pipe is configured to circulate the heat transfer fluid such that the heat transfer fluid may emit the heat energy into an environment of the housing. The heat pipe may be located in the duct structure on an outside of the housing.

Optionally the duct structure comprises a ventilation device for increasing the circulation of air, or another medium in the environment of the housing, through the duct structure. The ventilation device may e.g. be placed at an end of the duct structure, and configured to move the air or other medium through the duct structure. The ventilation device may require a power connection, which may connect the ventilation device with a power source in the interior of the housing, possibly by means of a waterproof and/or airtight connection line. In further embodiments, a power source (e.g. a battery) may be attached outside of the housing in order to provide energy for the ventilation device.

Optionally the housing comprises an outer surface which is equipped with a plurality of fins for heat dissipation. Such fins increase an area of the outer surface, and improve cooling by increasing convection.

Embodiments further relate to a radar apparatus comprising an electronic component and a housing as described before, wherein the electronic component is positioned in contact with the surface of the duct structure. The housing may comprise all electronic equipment for emitting and detecting radar signals by means of a radar antenna device. The radar apparatus may in particular comprise an active electronically scanned array or other phased array antenna.

Optionally the electronic component is a graphics processing unit, another processing unit, a particular plug-in device for a processing unit, or a power supply device.

Embodiments further relate to a method for providing a cooling effect for an electronic component in a closed housing, comprising the steps:
providing the housing with a duct structure configured to admit a circulation of air from an environment of the housing through the duct structure; and
placing the electronic component in contact with a surface of the duct structure on an interior side of the housing to thereby provide the cooling effect for the electronic component.

As an advantage provided by embodiments, the housing is capable of providing cooling in particularly challenging situations, e.g. where cooling has to be realized by natural convection only. Advantageously, electronic components with comparatively high heat production may be placed either next to an outside wall of the housing, or next to a surface of the duct structure. In a sense, the duct structure therefore increases the number of available outside walls. The airflow (or flow of another medium around the housing) through the duct structure, which may be enhanced by channels for provoking a stack (or chimney) effect, is based on natural convection and therefore free of maintenance. The duct structure may comprise multiple substructures, thus using the effect multiple times for a given housing.

### BRIEF DESCRIPTION OF THE DRAWINGS

Various embodiments of the present invention will be described in the following by way of examples only, and with respect to the accompanying drawings, in which:
- Fig. 1: depicts an embodiment of a closed housing for an electronic component according to the present invention.
- Fig. 2: depicts a further embodiment.
- Fig. 3: illustrates details of a duct structure.
- Fig. 4: illustrates a section and a top view of an embodiment of the housing.
- Fig. 5: shows steps of a method for providing a cooling effect for an electronic component in a closed housing.

### DETAILED DESCRIPTION

Various examples will now be described more fully with reference to the accompanying drawings, in which some embodiments are illustrated. Accordingly, while examples are capable of various modifications and alternative forms, the illustrative examples in the figures will herein be described in detail. It should be understood, however, that there is no intent to limit examples to the particular forms disclosed. On the contrary, examples are to cover all modifications, equivalents, and alternatives falling within the scope of the disclosure.

The terminology used herein is for the purpose of describing illustrative examples only and is not intended to be limiting. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, elements and/or components, but do not preclude the presence or addition of one or more other features, steps, elements, components and/or groups thereof.

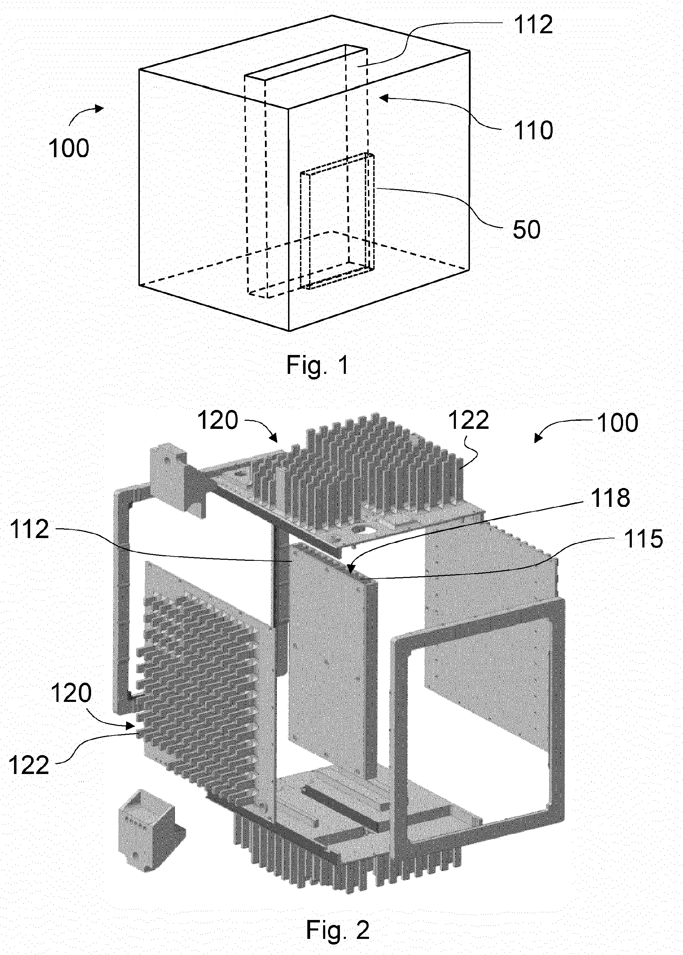

**Fig. 1** depicts a closed housing 100 for an electronic component 50 according to the present invention. The housing 100 comprises a duct structure 110 which passes through the housing 100, and has a surface 112 on an interior side of the housing 100 for attaching the electronic component 50. The duct structure 110 is configured to admit a circulation of air, or of another medium in an environment of the housing 100, through the duct structure 110. The air or medium does not enter the housing 100. The circulation provides a cooling effect for the electronic component 50. The electronic component 50 is attached to the surface 112, or placed in contact with the surface 112, such that heat produced by the electronic component 50 can dissipate through the surface 112 of the duct structure 110 into the air.

The housing 100 may be watertight and/or airproof. Within the housing 100, a fan may be employed to revolve air inside the housing, and heat pipes may be used to move heat from sources to the housing walls, or to the surface 112 of the duct structure 110. The electronic component 50 my be part of a larger electronic device contained in the housing 100, and the duct structure 110 may effectively be employed as a heat sink within an architecture of the electronic device.

Although not depicted here, it is emphasized that the duct structure 110 may comprise several disjoint parts, i.e. several canals or substructures, each for circulating the air or medium outside the housing and thus providing a cooling effect to one or more electronic components 50 within the housing 100.

The duct structure 110, or each of the canals or substructures that make it up, pass through, i.e. freely traverse, the housing 100. Neither does the duct structure 110 cut the housing 100 into several disjoint pieces, nor does the duct structure 110 merely consist of dents, grooves or slots in some surface of the housing 100. If the housing 100 is effectively viewed as a two-dimensional closed surface, the duct structure 110 is responsible for increasing the genus of this closed surface, i.e. the closed surface admits a non-contractible cycle running through the duct structure 110.

**Fig. 2** depicts a further embodiment. The housing 100 comprises several parts, some of which are depicted here, before an assembly. One of these parts is the duct structure 110. The duct structure 110 comprises several elongated fins 115, which form a plurality of channels for providing a chimney effect. As the electronic component 50 produces heat, the duct structure 110 heats up in a vicinity of the electronic component 50, providing a buoyancy force which leads to an increase in the circulation of air (or of another medium surrounding the housing) through the channels.

Some outer surfaces 120 of the housing 100 exhibit further fins 122, adapted for heat dissipation of heat produced within the housing 100 by electronic components 50, including power sources. These outer surfaces 120, or outer walls, of the housing 100, thereby also provide an increased dissipation of heat, produced by electronic components 50 in the housing 100 into an environment of the housing 100.

The housing 100 may in particular be configured to hold electronics for a radar apparatus. In the present embodiment, the housing 100 is configured to provide water- and/or airproof connection ports 131, 132, e.g. for connecting a radar antenna device. The radar apparatus may in particular exhibit an active electronically scanned array or other phased array antenna, and be configured to operate under severe weather conditions (e.g. in humid or wet surroundings, under strong wind impacts, or at high or low pressure and/or temperatures).

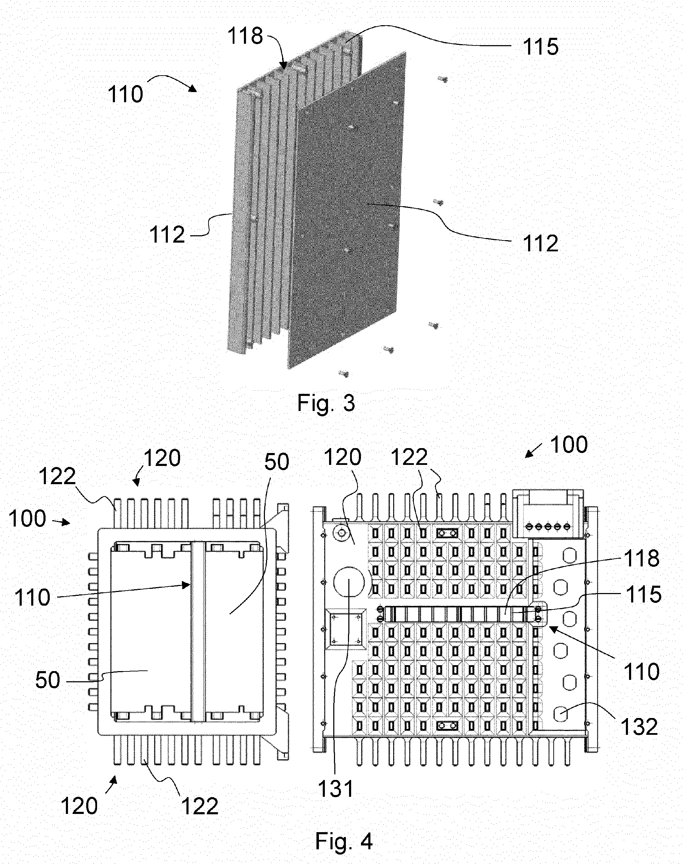

**Fig. 3** illustrates details of a duct structure 110 according to a particular embodiment. The duct structure 100 (or the particular canal of the duct structure depicted) comprises two plates which provide surfaces 112 for attaching electronic components 50, or for placing electronic components 50 next to the duct structure 110 in order to benefit from the cooling effect provided by the circulation of air through the duct structure 110. Between the plates there is a plurality of elongated fins 115, effectively forming a plurality of channels 118. Upon being heated up locally by the heat of the electronic component 50 (not depicted), the channels 118 provide a stack effect, or chimney effect, which further increases the circulation of air through the duct structure 110. The duct structure 110 of this embodiment provides the advantages of easy assembly and inclusion into a rest of the housing 100.

**Fig. 4** illustrates on a left side of the figure a section and on a right side of the figure a top view of an embodiment of the housing 100. The duct structure 110 provides two surfaces 112 in connection with two electronic components 50 of a radar apparatus. The duct structure 110 traverses the housing 110 and, although the section depicted on the left does not make this visible, admits a circulation of air through the duct structure 110 via openings in the outer surfaces 120 of the housing 100. The housing 100 provides several access ports 131, 132 for data connections from and to the electronic equipment comprised in the housing 100.

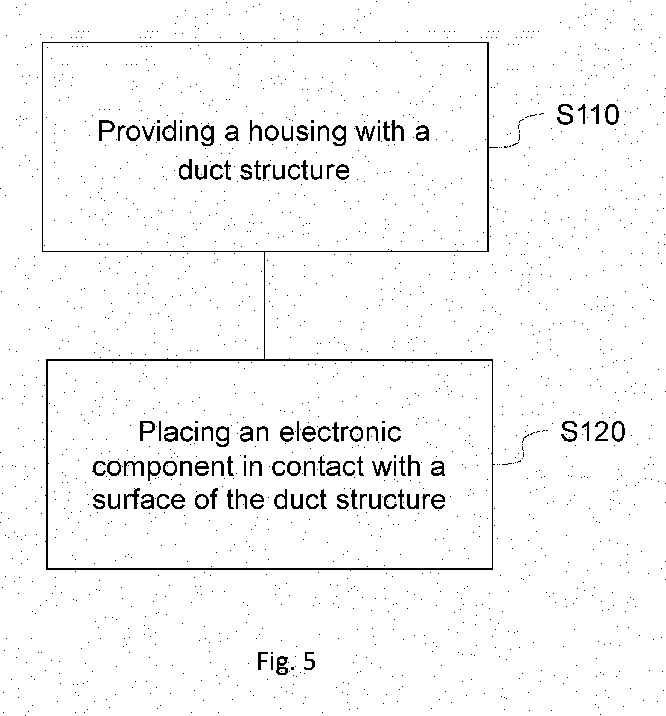

**Fig. 5** shows steps of a method for providing a cooling effect for an electronic component 50 in a closed housing 100. A first step comprises providing (S110) the housing 100 with a duct structure 110, wherein the duct structure 110 is configured to admit a circulation of air in an environment of the housing 100 through the duct structure 110. The method further comprises placing the electronic component 50 in contact with a surface 112 of the duct structure 110, on an interior side of the housing 100, to thereby provide the cooling effect for the electronic component 50.

The description and drawings merely illustrate the principles of the disclosure. It will thus be appreciated that those skilled in the art will be able to devise various arrangements that, although not explicitly described or shown herein, embody the principles of the disclosure and are included within its scope.

Furthermore, while each embodiment may stand on its own as a separate example, it is to be noted that in other embodiments the defined features can be combined differently, i.e. a particular feature described in one embodiment may also be realized in other embodiments. Such combinations are covered by the disclosure herein.

Although the invention has been illustrated and described in detail by way of preferred embodiments, the invention is not limited by the examples disclosed, and other variations can be derived from these by the person skilled in the art without leaving the scope of the invention. It is therefore clear that there is a plurality of possible variations. It is also clear that embodiments stated by way of example are not to be seen as limiting the scope, application possibilities, or configuration of the invention in any way. In fact, the preceding description and the description of the figures enable the person skilled in the art to implement the exemplary embodiments in concrete manner, wherein, with the knowledge of the disclosed inventive concept, the person skilled in the art is able to undertake various changes, for example, with regard to the functioning or arrangement of individual elements stated in an exemplary embodiment without leaving the scope of the invention.

### List of reference signs

- 50: electronic component
- 100: housing
- 110: duct structure
- 112: surface
- 115: fin
- 118: channel
- 120: outer surface of housing
- 122: further fin
- 131, 132: connection ports
- S110, S120: steps of a method

## Claims

1. A closed housing (100) for an electronic component (50), the housing (100) comprising:
a duct structure (110) passing through the housing (100) and having a surface (112) on an interior side of the housing (100) for attaching the electronic component (50),
wherein the duct structure (110) is configured to admit a circulation of air from an environment of the housing (100) through the duct structure (110), without entering the housing (100), and to thereby provide a cooling effect for the electronic component (50).

2. The housing (100) of claim 1, wherein the housing (100) encloses the electronic component (50) in a waterproof and/or airtight manner.

3. The housing (100) according to one of the preceding claims, wherein the duct structure (110) comprises a plurality of channels (118) configured to provide or improve a stack effect for cooling the electronic component (50).

4. The housing (100) according to claim 3, wherein the plurality of channels (118) is formed by fins (115) comprised in the duct structure (110).

5. The housing (100) according to one of the preceding claims, wherein the duct structure (110) comprises a heat pipe for cooling the electronic component (50).

6. The housing (100) according to one of the preceding claims, wherein the duct structure (110) comprises a ventilation device for increasing the circulation of air through the duct structure (110).

7. The housing (100) according to one of the preceding claims, wherein the housing (100) comprises an outer surface (120) equipped with a plurality of further fins (122) for heat dissipation.

8. A radar apparatus comprising an electronic component (50) and a housing (100) according to one of the preceding claims, wherein the electronic component (50) is positioned in contact with the surface (112) of the duct structure (110).

9. The radar apparatus according to claim 8, wherein the electronic component (50) is one of the following:
- a graphics processing unit,
- another processing unit,
- a plug-in device for a processing unit,
- a power supply device.

10. A method for providing a cooling effect for an electronic component (50) in a closed housing (100), comprising:
Providing (S110) the housing (100) with a duct structure (110) configured to admit a circulation of air from an environment of the housing (100) through the duct structure (110); and
placing the electronic component (50) in contact with a surface (112) of the duct structure (110) on an interior side of the housing (100) to thereby provide the cooling effect for the electronic component (50).
